# EUROPEAN PATENT APPLICATION

(11) **EP 2 426 183 A1**
(43) Date of publication of application: **07.03.2012**
(21) Application number: 11179437.6
(22) Date of filing: 31.08.2011
(51) Int. Cl.: C09J 7/02, C09J 5/06

(54) **Temporary fixing sheet for manufacturing process of electronic parts**

(30) Priority: 01.09.2010 JP 2010196251
(71) Applicant: NITTO DENKO CORPORATION, Ibaraki-shi, Osaka 567-8680 (JP)
(72) Inventor: Shimokawa, Daisuke, Ibaraki-shi, Osaka 567-8680 (JP); Shimazaki, Yuta, Ibaraki-shi, Osaka 567-8680 (JP); Nagasaki, Kunio, Ibaraki-shi, Osaka 567-8680 (JP); Imoto, Eiichi, Ibaraki-shi, Osaka 567-8680 (JP)
(74) Representative: Grünecker, Kinkeldey, Stockmair & Schwanhäusser

(57) **Abstract**

The present invention provides a temporary fixing sheet which firmly holds a ceramic sheet in a cutting step for the ceramic sheet and the like, can provide high cutting accuracy, and then can efficiently and easily peel a chip from itself by being cooled to a predetermined temperature or lower, with a high degree of freedom in designing and adequate handleability. The temporary fixing sheet includes a supporting substrate and a temporary fixing layer provided on at least one face thereof, wherein the temporary fixing layer contains a urethane polymer and a vinyl polymer.

## Description

### BACKGROUND OF THE INVENTION

### Field of the Invention

The present invention relates to a temporary fixing sheet for a manufacturing process of electronic parts, which makes an adherend workable with high accuracy and can be efficiently and easily peeled off.

### Description of the Related Art

As a pressure-sensitive adhesive tape which is used in working on electronic parts, an arbitrary one has been selected from pressure-sensitive adhesive tapes and used, in which a tackiness agent such as an acrylic base, a urethane base, a rubber base and a silicon base is laminated on a substrate such as a polyester base, a polyolefin base, a vinyl-chloride base, an acrylic base, a polyurethane base, a rubber base and a fluorine base. On this occasion, the pressure-sensitive adhesive tape has sufficient tackiness at a certain point in time, and has been subjected to treatment such as a heating treatment, cooling treatment and light irradiation so as not to have tackiness at another point in time.

In the field of recent electronic parts, the miniaturization and refinement of the parts themselves have been required, and, for instance, in a ceramic capacitor, a ceramic resistor and a ceramic inductor, which are electronic parts made from ceramics, the achievements in miniaturization and higher capacitance due to stacking layers so as to greatly exceed several hundreds of layers as represented by parts such as "0603" and "0402", have been remarkable.
Particularly, in the process of manufacturing the ceramic capacitor, high working accuracy has been required in order to attain the miniaturization and refinement.
Taking the process of manufacturing a ceramic capacitor as one example, there are the following steps:
(1) a step of printing an electrode onto a green sheet,
(2) a stacking step
(3) a pressing step
(4) a cutting step
(5) a heat-peeling step
(6) a step of applying and drying an external electrode, and the like.
However, various accuracies are required such as accuracy in the electrode printing in step (1), accuracy in the electrode position in step (2), accuracy in preventing the displacement of the electrode position from occurring due to a deformation of the green sheet by pressurization and a consequent displacement of the electrode position in step (3), and accuracy in cutting in step (4). If the accuracy in even one of these steps is poor, the product becomes faulty and the productivity will be degraded.

Particularly, the above described steps (1) to (4) are conducted generally on a PET film or pressure-sensitive adhesive sheet, and a manufacturing method which uses particularly the pressure-sensitive adhesive sheet is often used from the viewpoint of holding (fixing) the green sheet in the cutting step. As for the pressure-sensitive adhesive sheet which is used for such application, various heat peelable type pressure-sensitive adhesive sheets have been proposed.

In the above described cutting step (4), a dicing technique using a rotary blade has been employed conventionally, but along with the miniaturization of the size, a press-cutting technique is being used which shows a higher yield than that of the dicing technique. However, the press-cutting technique has such a problem that chips adhere to each other again in the case of some ceramic sheets. This occurs due to a factor that in the press-cutting technique, there is almost no gap between the chips which have been cut, and accordingly the ceramic sheets adhere to each other again, particularly because in the heat-peeling step, the ceramic sheets themselves are softened by a heat history and acquire tackiness, which is different from that of the dicing technique.

In response to this, in order to prevent the chips from adhering to each other again in the heat-peeling step, the temporary fixing sheet containing a side-chain crystallizable polymer has been proposed in recent years, which firmly holds the ceramic sheet when the ceramic sheet is cut at approximately 40°C to 100°C and then decreases the tackiness of the pressure-sensitive adhesive layer of the pressure-sensitive adhesive sheet by being cooled to room temperature without undergoing a heating treatment step, and therefore the chips can be peeled off, (Japanese Patent No. 3387497 and Japanese Patent No. 3485412, for instance). By using this sheet, the heating treatment step after the ceramic sheet has been cut can be omitted, and accordingly the readherence of the chip originating in the step can be reduced.

Furthermore, as is described in Japanese Patent Laid-Open No. 2002-208537, the method is known which includes press-cutting the ceramic stacked body, by sticking the ceramic stacked body made of stacked ceramic green sheets onto a pressure-sensitive adhesive sheet having a tackiness agent applied onto a substrate made from a plant fiber having a large number of air bubbles therein, and adsorbing and retaining the resultant pressure-sensitive adhesive sheet.

The method for manufacturing the ceramic capacitor with the use of the above described heat-peelable tape tends to make the chips adhere to each other again in the heat-peeling step, as was described above. In addition, there is a case in which the electronic parts are overloaded due to the heat-peeling step, producing a harmful influence on the product. Furthermore, the manufacturing method needs a heating step, and accordingly the installation of more equipment is required.
Furthermore, the above described temporary fixing sheet containing the side-chain crystallizable polymer cannot provide high cutting accuracy, although higher cutting accuracy in the cutting step (4) as well as the prevention of the readherence of the chips is demanded along with the miniaturization of chips.

In addition, the above described temporary fixing sheet containing the side-chain crystallizable polymer can make the tack strength disappear by being cooled, but needs to introduce a large amount of crystalline materials so as to make the tack strength disappear. Then, the degree of freedom in designing will be lost. In addition, the crystalline material needs to have a melting temperature of the crystal equal to or higher than room temperature, in order that the temporary fixing sheet is peeled at a room temperature, needs to be warmed when the pressure-sensitive adhesive tape is produced and consequently is poor in the handleability. Accordingly, it is difficult to be handled in the manufacture.
The present invention is directed at solving such defects, and an object thereof is to provide a temporary fixing sheet which firmly holds a ceramic sheet in a cutting step for the ceramic sheet, can provide high cutting accuracy, and then can efficiently and easily peel the chip from the temporary fixing sheet by being cooled to a predetermined temperature or lower, with a high degree of freedom in designing and adequate handleability.

### SUMMARY OF THE INVENTION

As a result of having made an extensive investigation for solving the above described problems, the present inventors found out that a temporary fixing sheet which has an adequate balance between the tack strength when having been warmed and peelability when having been cooled to room temperature and has high elasticity imparted even when having been warmed can be obtained by using a material containing a urethane polymer content and a vinyl polymer as active ingredients.
Specifically,
1. A temporary fixing sheet for a manufacturing process of electronic parts comprising a supporting substrate and a temporary fixing layer provided on at least one face thereof, wherein the temporary fixing layer contains a urethane polymer and a vinyl polymer;
2. The temporary fixing sheet for the manufacturing process of the electronic parts according to aspect 1, wherein the vinyl polymer contains a carboxyl group;
3. The temporary fixing sheet for the manufacturing process of the electronic parts according to aspect 1 or 2, wherein at least one part of the urethane polymer is a urethane polymer having an acryloyl group in a terminal end;
4. The temporary fixing sheet for the manufacturing process of the electronic parts according to any one of aspects 1 to 3, wherein the temporary fixing sheet develops tack strength at a particular temperature equal to or higher than 40°C, and loses the tack strength at lower than the particular temperature;
5. The temporary fixing sheet for the manufacturing process of the electronic parts according to any one of aspects 1 to 4, wherein tack strength with respect to a PET film under an atmosphere of 80°C is 0.2 N / 20 mm or more, and tack strength with respect to the PET film which has been measured under an atmosphere of 25°C, is 0.1 N / 20 mm or less;
6. The temporary fixing sheet for the manufacturing process of the electronic parts according to any one of aspects 1 to 5, wherein a storage modulus G' at 80°C is 10⁵ Pa or more;
7. The temporary fixing sheet for the manufacturing process of the electronic parts according to any one of aspects 1 to 6, wherein the temporary fixing sheet is used for cutting the electronic parts; and
8. The temporary fixing sheet for the manufacturing process of the electronic parts according to aspect 7, wherein the temporary fixing sheet is used for press-cutting a multilayered ceramic sheet.

The temporary fixing sheet according to the present invention can be preferably used as a temporary fixing sheet for use in working on electronic parts such as stacked ceramic electronic parts. When the temporary fixing sheet is used in a press-cutting step of a multilayered ceramic sheet under a high-temperature atmosphere, for instance, the above described temporary fixing sheet can prevent the chip from being peeled during the operation because of having high tackiness under the high-temperature atmosphere, and the multilayered ceramic sheet can be cut with high accuracy because the temporary fixing layer has a high storage modulus in a range of a cutting temperature. Furthermore, the temporary fixing sheet is not one which can be peeled by heating, but can peel a chip from itself by simply being cooled to room temperature without undergoing a heating treatment step, and accordingly can prevent the chips from adhering to each other again in the heating treatment step.
Because the temporary fixing layer of the temporary fixing sheet does not need to employ a crystalline material, it shows adequate handleability when the sheet is prepared, is excellent in the productivity, does not need a heating step, and accordingly can provide an effect of temporary fixation with a simple and easy method.
Accordingly, the temporary fixing sheet shows an effect of working on electronic parts with high accuracy and being capable of efficiently and easily collecting the electronic parts.
The temporary fixing sheet for the manufacturing process of the electronic parts according to the present invention can be extended by stretching, and can also further reduce the readherence of the chips because of being capable of forming a gap between the chips by being stretched after the cutting step.

### BRIEF DESCRIPTION OF THE DRAWINGS

FIG. 1 is a schematic sectional view partially illustrating one example of a temporary fixing sheet according to the present invention; and
FIG. 2 is a view of a step of press-cutting a multilayered ceramic sheet with the use of the temporary fixing sheet according to the present invention.

### Reference Signs List

1 ... Supporting substrate
2 ... Temporary fixing layer
3 ... Release layer
4 ... Pedestal
5 ... multilayered ceramic sheet
6 ... Press-cutting blade

### DETAILED DESCRIPTION OF THE PREFERRED EMBODIMENTS

The constitution of the temporary fixing sheet according to the present invention will be described below with reference to the drawings, as needed.

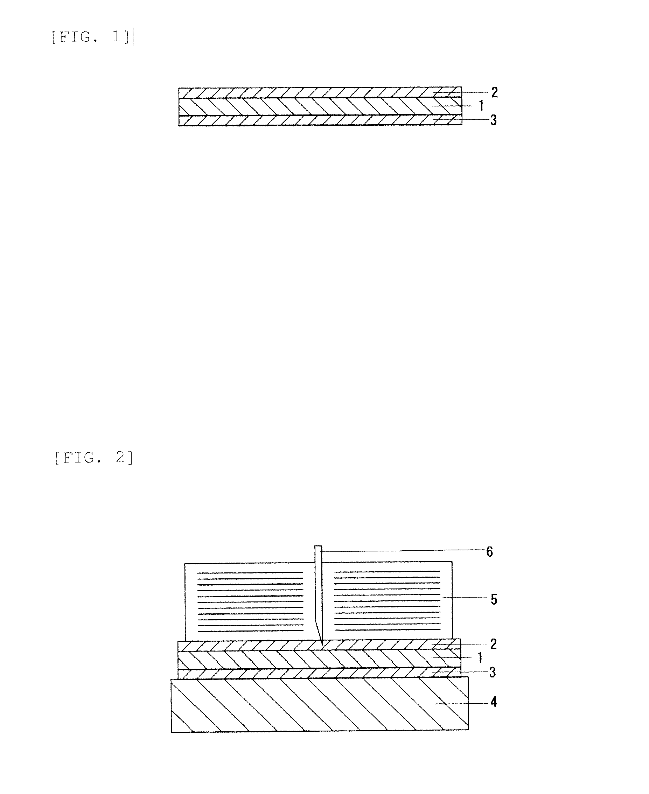

In FIG. 1, reference numeral 1 denotes a supporting substrate, reference numeral 2 a temporary fixing layer and reference numeral 3 a release layer.
The release layer 3 is a layer provided as needed, and is not an indispensable layer for the temporary fixing sheet according to the present invention.

The temporary fixing sheet according to the present invention can also be a double-sided type temporary fixing sheet having a temporary fixing layer provided on both faces of the supporting substrate 1. On this occasion, any one of the temporary fixing layers may contain a urethane polymer and a vinyl polymer as active ingredients, and the other temporary fixing layer may also be constituted by any type of tackiness agents. For information, in the present invention, a word "film" has a concept including a sheet, and a word "sheet" has a concept including a film. As described herein, the temporary fixing layer contains the urethane polymer and the vinyl polymer as active ingredients, which means that these polymers may be blended and may also be bonded to each other.
Furthermore, the temporary fixing layer can also have a release sheet stacked on the respective surfaces of the temporary fixing layer and the release layer, so as to protect the surfaces.

### (Supporting substrate)

A supporting substrate 1 shall work as a base which supports a temporary fixing layer, and generally a plastic film or sheet of PET or the like is used for the supporting substrate 1, but an appropriate tissue body can be used, for instance, paper, cloth, non-woven fabric, metal foil and the like, or a laminate thereof with plastic, and a laminate of plastic films (or sheets). The thickness of the supporting substrate 1 is generally 500 µm or less, and is preferably approximately 5 to 250 µm, but is not limited to these thicknesses.
The surface of the supporting substrate 1 may also be subjected to conventional surface treatment, for instance, such as chromate treatment, ozone exposure, flame exposure, high-pressure electric shock exposure and ionized radiation treatment, in order to enhance the adhesiveness to an adjacent layer (in this case, temporary fixing layer 2).

### (Urethane polymer)

A urethane polymer to be used for a temporary fixing layer 2 is obtained by making a polyol react with a diisocyanate. For a reaction of the hydroxyl group of the polyol and the isocyanate, a catalyst may also be used which is generally used in a urethane reaction, for instance, such as dibutyltin dilaurate, tin octoate and 1,4-diazabicyclo(2, 2, 2)octane.

The polyol includes: a polyether polyol obtained by addition-polymerizing ethylene oxide, propylene oxide, tetrahydrofuran and the like; a polyester polyol formed of a condensation polymer which is obtained by condensation-polymerizing the above described divalent alcohol with a divalent basic acid such as adipic acid, azelaic acid and sebacic acid; acrylic polyol; carbonate polyol; epoxy polyol; and caprolactone polyol. Among these polyols, a polyol to be preferably used is, for instance, a polyether polyol such as polyoxytetramethylene glycol (PTMG) and polyoxypropylene glycol (PPG); a noncrystalline polyester polyol; and a noncrystalline polycarbonate polyol. These polyols can be used solely or concomitantly with another polyol.

The diisocyanate includes an aromatic, an aliphatic and an alicyclic diisocyanate. The aromatic, the aliphatic and the alicyclic diisocyanates include tolylene diisocyanate, diphenylmethane diisocyanate, hexamethylene diisocyanate, xylylene diisocyanate, hydrogenated xylylene diisocyanate, isophorone diisocyanate, hydrogenated diphenylmethane diisocyanate, 1,5-naphthylene diisocyanate, 1,3-phenylene diisocyanate, 1,4-phenylene diisocyanate, butane-1,4-diisocyanate, 2,2,4-trimethyl hexamethylene diisocyanate, 2,4,4-trimethyl hexamethylene diisocyanate, cyclohexane-1,4-diisocyanate, dicyclohexylmethane-4,4-diisocyanate, 1,3-bis(isocyanatemethyl) cyclohexane, methyl cyclohexane diisocyanate, and m-tetramethyl xylylene diisocyanate. These diisocyanates can be used solely or concomitantly with another diisocyanate. The type, the combination and the like of the polyisocyanate can be appropriately selected from the viewpoint of urethane reactivity, compatibility with acrylic and the like.

The amounts of the above described polyol component and the above described diisocyanate component to be used for forming the urethane polymer are not limited in particular, but the amount of the polyol component to be used preferably satisfies, for instance, a condition that NCO/OH (equivalence ratio) with respect to the diisocyanate component is 1.0 or more and further preferably satisfies that the NCO/OH is 2.0 or less. When the NCO/OH is 1.0 or more, a functional group in the terminal of a urethane molecule chain becomes a hydroxyl group, and the strength decrease of the temporary fixing layer can be prevented. In addition, when the NCO/OH is 2.0 or less, moderate elongation and strength can be secured.

The molecular weight of the urethane polymer component in the present invention can be appropriately determined by the type and the NCO/OH ratio of the polyol and the diisocyanate to be used. The molecular weight is not limited in particular, but is preferably 5,000 or more by a number average molecular weight (Mw), and further preferably is 10,000 or more.

It is desirable to add a hydroxyl-group-containing acrylic monomer to the above described urethane polymer other than the vinyl polymer in the present invention. By the addition of the hydroxyl-group-containing acrylic monomer, an acryloyl group can be introduced into the molecule of a urethane polymer, and copolymerizability with the acrylic monomer can be imparted. The hydroxyl-group-containing acrylic monomer to be used includes hydroxyethyl (meth)acrylate, hydroxypropyl (meth)acrylate and hydroxyhexyl (meth)acrylate. The amount of the hydroxyl-group-containing acrylic monomer to be used is desirably 0.1 to 10 parts by weight with respect to 100 parts by weight of the urethane polymer, and further desirably is 0.1 to 5 parts by weight.

### (Vinyl polymer)

A vinyl polymer to be used for a temporary fixing layer according to the present invention may be obtained by blending the above described urethane polymer and the following vinyl polymer, and may also be obtained by preparing a mixture of the urethane polymer and the vinyl polymer, and then polymerizing the vinyl polymer.
Among the methods, it is preferable to form the vinyl polymer by making a polyol react with an isocyanate in a single vinyl polymer or in a mixture of two or more vinyl polymers to form a urethane polymer, applying the obtained mixture containing the urethane polymer and the vinyl monomer onto a substrate, and irradiating the wet film with a radiation to cure the wet film, from the points of the type of a usable monomer, workability in forming a sheet and the like. The vinyl monomer is preferably a (meth)acrylic monomer.

As was described above, it is also possible to form a resin in which an acryloyl group is polymerized with a vinyl group and the urethane polymer is coupled with the vinyl polymer, by introducing the acryloyl group into the urethane polymer with the use of the hydroxyl-group-containing acrylic monomer and polymerizing the vinyl monomer.

The vinyl polymer in the present invention is a polymer which is obtained by polymerizing a vinyl monomer, and a (meth)acrylic monomer is preferably used for the vinyl monomer as was described above. The (meth)acrylic monomer includes, for instance: a carboxyl-group-containing monomer such as ethyl (meth)acrylate, n-propyl (meth)acrylate, isopropyl (meth)acrylate, n-butyl (meth)acrylate, sec-butyl (meth)acrylate, t-butyl (meth)acrylate, n-octyl (meth)acrylate, isooctyl (meth)acrylate, 2-ethylhexyl (meth)acrylate, isononyl (meth)acrylate, dodecyl (meth)acrylate, n-octadecyl (meth)acrylate, acrylic acid, methacrylic acid, carboxyethyl acrylate, carboxypentyl acrylate, itaconic acid, maleic acid and crotonic acid; a hydroxyl-group-containing monomer such as 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate and (4-hydroxymethyl cyclohexyl)-methyl acrylate; a monomer having an alicyclic structure such as cyclohexyl (meth)acrylate and isobornyl acrylate; an acid anhydride monomer such as maleic anhydride and itaconic anhydride; a sulfonate-group-containing monomer such as 2-acrylamide-2-methylpropanesulfonic acid and sulfopropyl acrylate; and a phosphate-containing monomer such as 2-hydroxyethyl acryloyl phosphate. In addition, the vinyl polymer in the present invention can employ one or more monomers of: an amide-based monomer such as (meth)acrylamide and an N-substituted (meth)acrylamide such as N-methylolacrylamide; a succinimido-based monomer such as N-(meth)acryloyloxymethylene succinimido, N-(meth)acryloyl-6-oxyhexamethylene succinimido and N-(meth)acryloyl-8-oxyoctamethylene succinimido; a vinyl monomer such as vinyl acetate, N-vinyl pyrrolidone, N-vinyl carboxylic amides and N-vinyl caprolactam; a cyanoacrylate-based monomer such as acrylonitrile and methacrylonitrile; an acrylic ester-based monomer such as glycidyl (meth)acrylate, tetrahydrofurfuryl (meth)acrylate, polyethylene glycol (meth)acrylate, polypropylene glycol (meth)acrylate, a fluorine-containing (meth)acrylate, a silicone (meth)acrylate, and 2-methoxyethyl acrylate; and a monomer such as methyl (meth)acrylate and octadecyl (meth)acrylate. The type, combination, amount to be used and the like of these (meth)acrylic monomers are appropriately determined in consideration of compatibility with urethane, polymerizability when being cured with light such as radiation and characteristics of a high polymer to be obtained. When the monomer having a polar group such as (meth)acrylate is used, the balance of the tack strengths between a warmed period and a cooled and peeled period is adequate.

When the amount of the (meth)acrylic acid to be added is preferably 5 parts by weight or more and less than 80 parts by weight when the whole amount of the urethane polymer and the vinyl polymer is supposed to be 100 parts by weight, and further preferably is 10 parts by weight or more and less than 70 parts by weight. When the amount to be added is set to 5 parts by weight or more, the temporary fixing sheet tends to easily acquire the balance of the tack strengths between the warmed period and the cooled and peeled period, and when the amount to be added is set to less than 80 parts by weight, the temporary fixing sheet acquires flexibility and an enhanced tack strength in the warmed period.

In the present invention, another polyfunctional monomer in such a range as not to impair the characteristics can also be added. The polyfunctional monomer includes hexanediol diacrylate, trimethylolpropane triacrylate and dipentaerythritol hexaacrylate.

### (Temporary fixing layer)

The temporary fixing layer according to the present invention contains a urethane polymer and a vinyl polymer as active ingredients. The ratio of the urethane polymer and the vinyl polymer is not limited in particular, but is preferably 10% or more and less than 90% by the weight of the urethane polymer occupying in the total amount of the urethane polymer and the vinyl polymer, and further preferably is 20% or more and less than 80%. When the ratio of the urethane polymer is 10% or more, the elastic modulus at a high temperature does not become low, and sufficient working accuracy can be obtained. When the ratio is 90% or less, the handlability and productivity when the sheet is produced are adequate.

The temporary fixing sheet according to the present invention can be obtained by: forming an urethane polymer by making a polyol react with an isocyanate in a vinyl monomer which constitutes a vinyl polymer by polymerization solely or in a mixture of two or more vinyl monomers; applying the mixture containing the urethane polymer and the vinyl monomer onto a supporting substrate; and irradiating the wet film with an ionizing radiation such as α rays, β rays, γ rays, neutron rays and an electron beam, a radiation such as ultraviolet rays, visible light and the like according to the type of a photopolymerization initiator and the like to photocure the wet film.

In addition, when the above described hydroxyl-group-containing acrylic monomer is used, the temporary fixing sheet can be obtained by: forming a urethane polymer by making a polyol react with an isocyanate in a vinyl monomer which constitutes a vinyl polymer by polymerization solely or in a mixture of two or more vinyl monomers; adding the hydroxy-group-containing acrylic monomer to the urethane polymer to make the acrylic monomer react with the urethane polymer; applying the obtained mixture onto a supporting substrate; and irradiating the wet film with an ionizing radiation such as α rays, β rays, γ rays, neutron rays and an electron beam, a radiation such as ultraviolet rays, a visible light and the like according to the type of the photopolymerization initiator and the like to cure the wet film.

Specifically, the temporary fixing sheet can also be obtained by: dissolving a polyol in a vinyl monomer; adding a diisocyanate or the like to the polyol to make the diisocyanate react with the polyol; adjusting the viscosity; coating a supporting substrate or the like with the reaction product; and curing the wet film with the use of a low-pressure mercury lamp or the like. In this method, the vinyl monomer may be added at a time during the synthesis of the urethane, and may also be added at several divided times. In addition, it is also acceptable to dissolve the diisocyanate into the vinyl monomer and then make the diisocyanate react with the polyol. According to this method, the molecular weight of the urethane to be finally obtained can be designed so as to become an arbitrary size, because the molecular weight is not limited and polyurethane with a high molecular weight can also be produced.

On this occasion, in order to avoid polymerization inhibition due to oxygen, a substrate which has been subjected to peeling treatment may be placed on the mixture of the urethane polymer and the vinyl monomer to block oxygen, which has been applied onto the supporting substrate, or a peeling liner may be put into a container which has been filled with an inactive gas, to lower the oxygen concentration.

In addition, a small amount of a solvent may also be added to the mixture for adjusting the viscosity to an adequate value for coating. The solvent can be appropriately selected from solvents to be usually used, but includes, for instance, ethyl acetate, toluene, chloroform and dimethylformamide.

In the present invention, the type of radiation and the like and the type of a lamp to be used for irradiation can be appropriately selected. A usable lamp includes a low-pressure lamp such as a fluorescent chemical lamp, a black light and a bactericidal lamp, and a high-pressure lamp such as a metal halide lamp and a high-pressure mercury lamp.
The amount of irradiation with ultraviolet rays and the like can be arbitrarily set according to characteristics to be required for a temporary fixing layer. The amount of irradiation with the ultraviolet rays is generally 50 to 5,000 mJ/cm², preferably is 100 to 4,000 mJ/cm², and further preferably is 100 to 3,000 mJ/cm². When the amount of irradiation with the ultraviolet rays is in the range of 50 to 5,000 mJ/cm², a sufficient polymerization ratio is obtained without causing degradation.

A photopolymerization initiator is included in the mixture which contains the urethane polymer and the vinyl monomer as a main component. The photopolymerization initiator includes: a benzoin ether such as benzoin methyl ether, benzoin isopropyl ether and 2,2-dimethoxy-1,2-diphenylethane-1-on; a substituted benzoin ether such as anisole methyl ether; a substituted acetophenone such as 2,2-diethoxyacetophenone, 2,2-dimethoxy-2-phenyl acetophenone and 1-hydroxy-cyclohexyl-phenyl ketone; a substituted α-ketol such as 2-methyl-2-hydroxypropiophenone; an aromatic sulfonyl chloride such as 2-naphthalene sulfonyl chloride; a photoactive oxime such as 1-phenyl-1,1-propanedione-2-(o-ethoxycarbonyl)-oxime; and acyl phosphine oxide such as 2,4,6-trimethylbenzoyl-diphenyl-phosphine oxide and bis(2,4,6-trimethylbenzoyl)-phenyl phosphine oxide.

The thickness of the temporary fixing layer in the present invention can be appropriately selected according to the purpose and the like, but is generally 5 to 500 µm and preferably is approximately 10 to 50 µm.
The temporary fixing sheet according to the present invention preferably has tack strength with respect to a PET film of 0.2 N / 20 mm or more under an atmosphere of 80°C, and tack strength with respect to the PET film of 0.1 N / 20 mm or less, which has been measured under an atmosphere at 25°C. In recent years, the press-cutting step is often conducted under a temperature around 80°C so as to enhance the cutting accuracy. When the tack strength under the temperature is 0.2 N / 20 mm or more, the ceramic sheet can be held without causing displacement when being cut. When the tack strength is 0.4 N / 20 mm or more, the ceramic sheet can be more surely held. In addition, when the temporary fixing sheet has been cooled to room temperature, if the tack strength with respect to the PET film is set at less than 0.1 N / 20 mm and more preferably at 0.05 N / 20 mm or less, the chip which has been cut can be easily peeled from the temporary fixing sheet.
In the present invention, the description that the temporary fixing layer develops the tack strength at a particular temperature equal to or higher than 40°C means that the temporary fixing layer develops the tack strength only when having reached a certain temperature equal to or higher than 40°C, which means that the temporary fixing layer does not develop the tack strength at a temperature lower than the certain temperature, and eventually means that the temporary fixing layer does not show the tack strength at a temperature lower than 40°C at least.
The temporary fixing layer in the present invention has a storage modulus G' preferably of 10⁵ Pa or more at 80°C. When the storage modulus G' is less than 10⁵ Pa, high working accuracy cannot be obtained in the cutting step or the like.

### (Release layer)

The release layer in the present invention can be a layer having the same composition as that of the above described temporary fixing layer, but can also be a layer which has a composition different from the above described temporary fixing layer and has repeelability,
Such a layer having the repeelability may be a layer made from a well known repeelable tackiness agent, also be a layer which shows the peelability as a result of having been heated or having been irradiated with an energy beam such as ultraviolet rays to decrease the tack strength, and also be a layer which is easily peeled by an application of a peeling force stronger than the tack strength because the tack strength is not so strong originally.

### (Application of temporary fixing sheet)

The temporary fixing sheet according to the present invention can be used as a pressure-sensitive adhesive sheet for use in temporarily fixing, storing or transporting various adherends. The application is not limited in particular, but is particularly suitable for use as a material for temporarily fixing electronic parts when the electronic parts are worked.
By using the temporary fixing sheet according to the present invention, chip-shaped electronic parts, for instance, such as a multilayered ceramic capacitor and a multilayered ceramic varistor, can be preferably manufactured.

The temporary fixing sheet according to the present invention and a method for cutting the multilayered ceramic sheet which uses the temporary fixing sheet will be described below with reference to the drawings.
FIG. 1 illustrates a temporary fixing sheet according to the present invention. The temporary fixing sheet has a temporary fixing layer 2 provided on one face of a supporting substrate 1, and a release layer 3 provided on the other face thereof. Although not shown in the figure, release sheets can also be stacked on the surfaces of the temporary fixing layer and the release layer. Reference numerals 1 to 3 in FIG. 1 denote the same members as reference numerals 1 to 3 in FIG. 2. Reference numeral 4 denotes a pedestal and reference numeral 5 denotes a multilayered ceramic sheet. Reference numeral 6 denotes a press-cutting blade for cutting the multilayered ceramic sheet 5. The temporary fixing sheet according to the present invention firmly fixes the multilayered ceramic sheet 5 which is a body to be worked, by affixing its pressure-sensitive adhesive layer for temporary fixation onto the pedestal, and affixing the thermally expansive pressure-sensitive adhesive layer 3 onto the multilayered ceramic sheet 5.

A step of cutting the multilayered ceramic sheet 5 is conducted under a high-temperature atmosphere (60 to 100°C, for instance) for the purpose of enhancing cutting accuracy. In the temporary fixing sheet of the present invention, both layers of the temporary fixing layer 2 and the release layer 3 are excellent in a cohesive force and the tack strength under room-temperature and high-temperature atmospheres, and accordingly the temporary fixing sheet can firmly fix the multilayered ceramic sheet 5 throughout the whole period before and after the cutting step. Particularly, the temporary fixing layer 2 does not cause lifting and deformation under a temperature during the cutting operation, and accordingly prevents the displacement of the multilayered ceramic sheet 5, which is induced by the intrusion of the press-cutting blade 6 during the cutting operation. As a result, the chips can be precisely cut into a form of chip elements which are units of parts, with high accuracy.
After the cutting operation has been finished, the worked body (multilayered ceramic sheet 5 which has been cut) can be removed from the temporary fixing layer 2.
The multilayered ceramic sheet 5 which has been cut is collected by an appropriate method, and then the release layer 3 of the temporary fixing sheet according to the present invention can be peeled from the pedestal 4 by a peeling operation or the like.
The release layer may not be used. In this case, the supporting substrate 1 may also be fixed to the pedestal by means of such as adsorption.

### [Examples]

The present invention will be described further in detail below with reference to examples, but the present invention is not limited to these examples at all.

### (Example 1)

A urethane polymer - acrylic monomer mixture was obtained by: charging 50 parts by weight of isobornyl acrylate (IBXA) which functions as a (meth)acrylic monomer, and 72.8 parts by weight of poly(tetramethylene) glycol having a number average molecular weight of 650 (PTMG, made by Mitsubishi Chemical Corporation), which functions as a polyol, into a reaction container provided with a cooling pipe, a thermometer and a stirring device; adding 27.2 parts by weight of hydrogenated xylylene diisocyanate (HXDI, made by Mitsui Chemicals Polyurethanes, Inc.) dropwise into the mixture while stirring the mixture; and making the compounds react with each other at 65°C for 10 hours. After that, 6.5 parts by weight of 2-hydroxyethyl acrylate (HEA) were added dropwise into the mixture, the compounds were reacted further for 3 hours, and then 50 parts by weight of acrylic acid (AA) and 0.3 parts by weight of 2, 2-dimethoxy- 1, 2-diphenylethane-1-one (IRGACURE 651, made by Ciba Japan K.K) which functions as a photopolymerization initiator were added to the reaction product. Incidentally, the ratio of the used amounts of a polyisocyanate component and a polyol component was 1.25 by NCO/OH (equivalence ratio).
The mixture of the urethane polymer and the acrylic monomer was applied onto a PET film having a thickness of 38 µm and was peelably treated so that the thickness of the film after having been cured became 100 µm. A urethane-acrylic composite film was formed on the PET film, by placing the PET film which was peelably treated on the mixture and covered the mixture with the film, and then irradiating the face of this covered PET film with ultraviolet rays (illumination of 5 mW/cm² and light quantity of 1000 mJ/cm²) by using a black light to cure the mixture.

### (Example 2)

A urethane polymer - acrylic monomer mixture was obtained by: charging 80 parts by weight of isobornyl acrylate (IBXA) which functions as a (meth)acrylic monomer, 20 parts by weight of butyl acrylate (BA), and 72.8 parts by weight of poly(tetramethylene) glycol (PTMG, made by Mitsubishi Chemical Corporation), which has a number average molecular weight of 650 and functions as a polyol, into a reaction container provided with a cooling pipe, a thermometer and a stirring device; adding 27.2 parts by weight of HXDI dropwise into the mixture while stirring the mixture; and making the compounds react with each other at 65°C for 10 hours. After that, 6.5 parts by weight of 2-hydroxyethyl acrylate (HEA) were added dropwise into the mixture, the compounds were reacted further for 3 hours, and then 30 parts by weight of acrylic acid (AA) and 0.3 parts by weight of IRGACURE 651 which functions as a photopolymerization initiator were added to the reaction product. Incidentally, the ratio of the used amounts of a polyisocyanate component and a polyol component was 1.25 by NCO/OH (equivalence ratio).
The mixture of the urethane polymer and the acrylic monomer was applied onto a PET film having a thickness of 38 µm and was peelably treated so that the thickness of the film after having been cured became 100 µm. A urethane-acrylic composite film was formed on the PET film, by placing the PET film which was peelably treated on the mixture and covered the mixture with the film, and then irradiating the face of this covered PET film with ultraviolet rays (illumination of 5 mW/cm² and light quantity of 1000 mJ/cm²) by using a black light to cure the mixture.

### (Example 3)

An urethane polymer - acrylic monomer mixture was obtained by: charging 100 parts by weight of isobornyl acrylate (IBXA) which functions as a (meth)acrylic monomer, and 72.8 parts by weight of poly(tetramethylene) glycol (PTMG, made by Mitsubishi Chemical Corporation) having a number average molecular weight of 650, which functions as a polyol, into a reaction container provided with a cooling pipe, a thermometer and a stirring device; adding 27.2 parts by weight of HXDI dropwise into the mixture while stirring the mixture; and making the compounds react with each other at 65°C for 10 hours. After that, 6.5 parts by weight of 2-hydroxyethyl acrylate (HEA) were added dropwise into the mixture, the compounds were reacted further for 3 hours, and then 0.3 parts by weight of IRGACURE 651 which functions as a photopolymerization initiator were added to the reaction product. Incidentally, the ratio of the used amounts of a polyisocyanate component and a polyol component was 1.25 by NCO/OH (equivalence ratio).
The mixture of the urethane polymer and the acrylic monomer was applied onto a PET film having a thickness of 38 µm and was peelably treated so that the thickness of the film after having been cured became 100 µm. A urethane-acrylic composite film was formed on the PET film, by placing the PET film which was peelably treated on the mixture and covered the mixture with the film, and then irradiating the face of this covered PET film with ultraviolet rays (illumination of 5 mW/cm² and light quantity of 1000 mJ/cm²) by using a black light to cure the mixture.

### (Comparative Example 1)

After 100 parts by weight of an acrylic copolymer (2-ethylhexyl acrylate : ethyl acrylate : 2-hydroxyethyl acrylate = 70 parts by weight : 30 parts by weight : 5 parts by weight), and 3 parts by weight of isocyanate-based cross-linking agents (made by Nippon Polyurethane Industry Co., Ltd.: trade name "CORONATE L") were dissolved in toluene, the solution was applied onto a polyester film having a thickness of 100 µm so that the thickness of the film after having been dried became 10 µm.

### (Comparative Example 2)

An organic elastic layer 1 was formed by dissolving 100 parts by weight of an acrylic copolymer (2-ethylhexyl acrylate : ethyl acrylate : 2-hydroxyethyl acrylate = 70 parts by weight : 30 parts by weight : 5 parts by weight), and 2 parts by weight of an isocyanate-based cross-linking agent (made by Nippon Polyurethane Industry Co., Ltd.: trade name "CORONATE L") into toluene; and applying the solution onto a polyester film having a thickness of 100 µm so that the thickness of the film after having been dried became 15 µm. In addition, a thermally peelable pressure-sensitive adhesive layer 1 was formed by uniformly mixing and dissolving 100 parts by weight of an acrylic copolymer (2-ethylhexyl acrylate : ethyl acrylate : 2-hydroxyethyl acrylate = 70 parts by weight : 30 parts by weight : 5 parts by weight), 1.5 parts by weight of an isocyanate cross-linking agent (made by Nippon Polyurethane Industry Co., Ltd.: trade name "CORONATE L"), 10 parts by weight of a terpene phenol resin (made by Sumitomo Bakelite Co., Ltd.: trade name "SUMILITE RESIN PR-12603N"), 30 parts by weight of thermally expansive microspheres (made by Matsumoto Yushi-Seiyaku Co., Ltd.: trade name "Microsphere F50D") in toluene to produce a coating liquid; and applying the coating liquid onto a separator so that the thickness of the film after having been dried became 40 µm. After that, a thermally peelable type pressure-sensitive adhesive sheet was obtained by affixing the above described organic elastic layer and the thermally peelable pressure-sensitive adhesive layer to each other.

### (Comparative Example 3)

A partial polymer (monomer syrup) was obtained by: charging 85 parts by weight of cetyl acrylate, 10 parts by weight of methyl acrylate, 5 parts by weight of acrylic acid, 0.1 parts by weight of 2,2-dimethoxy-1,2-diphenylethane-1-on, into a four neck flask; and exposing the compounds to ultraviolet rays under nitrogen atmosphere to partially photopolymerize the compounds. A photopolymerized composition was prepared by adding 0.1 parts by weight of hexanediol diacrylate as a crosslinking agent to 100 parts by weight of this partial polymer, and uniformly mixing the compounds.
The above described photopolymerized composition was applied onto the peelably treated face of a polyethylene terephthalate film having the thickness of 38 µm, of which the one face was peelably treated with silicone, so that the thickness of the composition became 100 µm; furthermore, the composition was covered with a polyethylene terephthalate film having the thickness of 38 µm, of which the one face was peelably treated; and then the applied layer was formed. A target pressure-sensitive adhesive sheet was obtained by irradiating this sheet with ultraviolet rays having an illuminance of 5 mW/cm² (measured with TOPCON UVR-T1 having the maximum peak-sensitivity wave of 350 nm) by a light quantity of 1,000 mJ/cm² with the use of a black light (15W/cm).

### (Evaluation)

Tack strength, a storage modulus, sheet retainability, peelability for the chip, a readherence rate and the squareness of the chip were evaluated on the films obtained in Examples 1 to 3 and Comparative Examples 1, 2 and 3 according to the methods described below. The results are shown in Tables 2 and 3.

### Method for measuring tack strength at 80°C

Each of the films prepared in Examples and Comparative Examples was cut into a tape shape with a width of 10 mm and a length of 140 mm; the cut film was affixed to a PET film (20 mm width) having a thickness of 25 µm, on a hot plate at 80°C in conformity with JIS Z 0237; the affixed film was then set on a variable-angle peel test machine with a plate stand at 80°C, and was left there for 3 minutes; and the load was measured which was applied to a film when the film was peeled with a tensile angle of 180°C at a peeling speed of 300 mm/min.

### Method for measuring tack strength at 25°C

Each of the films was affixed to the PET film as in a method of measuring the tack strength at 80°C; the affixed film was left for 10 minutes on the hot plate at 80°C, then was cooled to 25°C, was set on a variable-angle peel test machine; and the load was measured which was applied to the film when the film was peeled with a tensile angle of 180°C at a peeling speed of 300 mm/min at 25°C.

### Method for measuring storage modulus G'

A storage modulus (G') was measured by "ARES" (made by TA Instruments Japan, Inc.). In the above procedure, the storage modulus was measured on conditions that the temperature range was -60°C to 200°C, a temperature-raising speed was 5°C/min and the frequency was 1 Hz.

### Method for measuring sheet retainability

Each multilayered ceramic sheet (*1) was affixed to each of the pressure-sensitive adhesive sheets obtained in Examples and Comparative Examples; the affixed sheet was left in an atmosphere of 80°C for 5 minutes; and then, the ceramic sheet was subjected to a press-cutting work (*2) so that the cut chip became the shape with a 0402 size (0.4 mm × 0.2 mm). The retainability for the ceramic sheet at this time was visually evaluated. Specifically, the case in which the ceramic sheet could be worked without causing the peeling and a displacement of the ceramic sheet or the cut chip when the ceramic sheet was cut was evaluated as "○", the case in which a little amount of cut chips were peeled or displaced was evaluated as "Δ", and the other cases were evaluated as "×".

### <*1 Method for preparing multilayered ceramic sheet>

A coating liquid for producing a ceramic sheet was prepared by mixing 100 parts by weight of barium titanate (made by Sakai Chemical Industry Co., Ltd.: trade name "BT-03/high purity perovskite"), 100 parts by weight (product dissolved in propylene glycol monoethylene ether, 10% base) of polyvinyl butyral (made by DENKI KAGAKU KOGYO KABUSHIKI KAISHA: trade name (PVB)), 6 parts by weight of bis-phthalate (made by J-PLUS Co., Ltd.: trade name DOP), 2 parts by weight of diglycerol oleate (Riken Vitamin Co., Ltd.: trade name RIKEMAL 0-71-D (E)) and 80 parts by weight of toluene while stirring the mixture. Subsequently, the above described coating liquid was applied onto a separator which had a silicone release agent applied to one face, so that the thickness of the film after having been dried became approximately 50 µm; the wet film was dried at 80°C for 5 minutes; and the ceramic sheet was obtained by being peeled from the separator. Ten sheets of the above ceramic sheets were stacked and pressed by a pressure of 300 kg/cm² to form the multilayered ceramic sheet.

### <*2 Press-cutting condition>

Maker of cutting apparatus: UHT Inc., Cutting temperature: 80°C, Cutting depth (amount of remnant from table face): approximately 75 um, and Cutting blade: thickness /100 µm and tip-part angle / 15°

### Peelability for chip

### <Sheet of Examples 1 to 3 and Comparative Examples 1 and 3>

Peelability for a chip was evaluated by: subjecting the multilayered ceramic sheet to the above described press-cutting work; cooling the temporary fixing sheet to which the cut ceramic sheet was affixed in conditions of a temperature of 25°C and a humidity of 65%; and peeling the cut chip from the temporary fixing sheet. Specifically, the case in which the chip was easily peeled from the temporary fixing sheet without causing damage or deformation in the chip was evaluated as "○", and the other cases were evaluated as "×".

### <Sheet of Comparative Example 2>

The peelability for the chip was evaluated by: subjecting the multilayered ceramic sheet to the above described press-cutting work; heating the temporary fixing sheet at 130°C for 10 minutes with a drier; and peeling the cut chip from a heat peelable type pressure-sensitive adhesive sheet. The evaluation criteria were the same as the above described one.

### Chip readherence rate

A readherence rate of chips was calculated from the rate of the number of the chips fusion-bonded to two or more adjacent chips with respect to the number of the whole cut chips.

### Squareness of chip

The squareness of the chip was measured by sampling each ten chips which were press-cut on each sheet, and observing the angle formed by the cut face and the bottom of the chip with a microscope.

**[Table 1]**

| Component required for producing resin layer in Examples 1 to 3 | | | | |
|---|---|---|---|---|
| | | Example 1 | Example 2 | Example 3 |
| Acrylic component | IBAXA | 50 | 80 | 100 |
| | AA | 50 | 30 | |
| | BA | | 20 | |
| Urethane component | PTMG | 72.8 | 72.8 | 72.8 |
| | HXDI | 27.2 | 27.2 | 27.2 |
| Reacting agent of urethane terminal | HEA | 6.5 | 6.5 | 6.5 |
| Photoinitiator | Irg651 | 0.3 | 0.3 | 0.3 |
| Urethane (%) | | 50 | 43.5 | 50 |
| Acrylic (%) | | 50 | 56.5 | 50 |

**[Table 2] Tack strength and storage modulus of temporary fixing sheet in Examples 1 to 3 and Comparative Examples 1 to 3**

| | Tack strength at 80°C (N/20mm) | Tack strength at 25°C (N/20mm) | Storage modulus at 80°C |
|---|---|---|---|
| Example 1 | 0.6 | 0.02 | 6.4×10⁵ |
| Example 2 | 1.1 | 0.05 | 4.9×10⁵ |
| Example 3 | 0.28 | 0.08 | 7.2×10⁵ |
| Comparative Example 1 | 0.03 | 3.0 | 3.6×10⁵ |
| Comparative Example 2 | 1.5 | 5.0 | 1.7×10⁵ |
| Comparative Example 3 | 0.9 | 0.03 | 1.5×10⁴ |

**[Table 3] Each measurement result of temporary fixing sheets in Examples 1 to 3 and Comparative Examples 1 to 3**

| | Sheet retainability | Peelability for chip | Readherence rate of chip | Squareness of chip |
|---|---|---|---|---|
| Example 1 | ○ | ○ | 0.03% | 90.2 |
| Example 2 | ○ | ○ | 0.05% | 90.3 |
| Example 3 | Δ | ○ | 0.05% | 90.3 |
| Comparative Example 1 | × | × | - | - |
| Comparative Example 2 | ○ | ○ | 1.2% | 90.5 |
| Comparative Example 3 | ○ | ○ | 0.04% | 91.2 |

The temporary fixing sheet for a manufacturing process of electronic parts according to the present invention (Examples 1 and 2) firmly held the ceramic sheet with a sufficient tack strength in a cutting step for the ceramic sheet at 80°C, also could provide high cutting accuracy, and could efficiently and easily peel the chip from itself by subsequently being cooled to a predetermined temperature or lower to decrease the tack strength to a level as shown in a tack strength at 25°C. In addition, the temporary fixing sheet was produced in a high degree of freedom in designing and with adequate handleability.

In addition, the temporary fixing sheet in Example 3 was fundamentally the same as the temporary fixing sheets in Examples 1 and 2, but had smaller tack strength at 80°C than that of the temporary fixing sheets in Examples 1 and 2, and accordingly a part of the chip was slightly peeled off or was displaced when the chips were cut during a press-cutting work.
In contrast to this, the sheet in Comparative Example 1 was displaced when the chips were cut during the press-cutting operation, and also the chip after having been cut was not peeled from the sheet. In addition, on the sheet of Comparative Example 2, many chips resulted in adhering to each other again because of undergoing a heating treatment step. The sheet in Comparative Example 3 showed an inferior result to the sheets in Examples 1 and 2, in the working accuracy (squareness of chip) of the chip after having been press-cut.

## Claims

1. A temporary fixing sheet for a manufacturing process of electronic parts comprising a supporting substrate and a temporary fixing layer provided on at least one face thereof, wherein the temporary fixing layer contains a urethane polymer and a vinyl polymer.

2. The temporary fixing sheet for the manufacturing process of the electronic parts according to claim 1, wherein the vinyl polymer contains a carboxyl group.

3. The temporary fixing sheet for the manufacturing process of the electronic parts according to claim 1 or 2, wherein at least one part of the urethane polymer is a urethane polymer having an acryloyl group in a terminal end.

4. The temporary fixing sheet for the manufacturing process of the electronic parts according to any one of claims 1 to 3, wherein the temporary fixing sheet develops tack strength at a particular temperature equal to or higher than 40°C, and loses the tack strength at lower than the particular temperature.

5. The temporary fixing sheet for the manufacturing process of the electronic parts according to any one of claims 1 to 4, wherein tack strength with respect to a PET film under an atmosphere of 80°C is 0.2 N / 20 mm or more, and tack strength with respect to the PET film which has been measured under an atmosphere of 25°C, is 0.1 N / 20 mm or less.

6. The temporary fixing sheet for the manufacturing process of the electronic parts according to any one of claims 1 to 5, wherein a storage modulus G' at 80°C is 10⁵ Pa or more.

7. The temporary fixing sheet for the manufacturing process of the electronic parts according to any one of claims 1 to 6, wherein the temporary fixing sheet is used for cutting the electronic parts.

8. The temporary fixing sheet for the manufacturing process of the electronic parts according to claim 7, wherein the temporary fixing sheet is used for press-cutting a multilayered ceramic sheet.
